# EUROPÄISCHE PATENTSCHRIFT

(11) **EP 1 367 716 B1**
(45) Veröffentlichungstag und Bekanntmachung des Hinweises auf die Patenterteilung: **04.06.2008**
(21) Anmeldenummer: 03005025.6
(22) Anmeldetag: 06.03.2003
(51) Int. Cl.: H03K 17/082

(54) **Schaltungsanordnung und Verfahren zum Überstrom-und Übertemperaturschutz von Leistungshalbleiterschaltern**
Circuit and method for protection of power semiconductors from overvoltage and overtemperature
Circuit et procédé pour protection de semiconducteurs de puissance contre des courants excessifs et de suréchauffement

(30) Priorität: 07.03.2002 DE 10210181
(43) Veröffentlichungstag der Anmeldung: 03.12.2003
(73) Patentinhaber: SEMIKRON Elektronik GmbH & Co. KG, 90431 Nürnberg (DE)
(72) Erfinder: Schreiber, Dejan, 90408 Nürnberg (DE)

(56) Entgegenhaltungen:
- US-A- 4 423 457
- US-A- 4 525 765
- US-A- 4 954 917
- US-A- 5 978 194

## Beschreibung

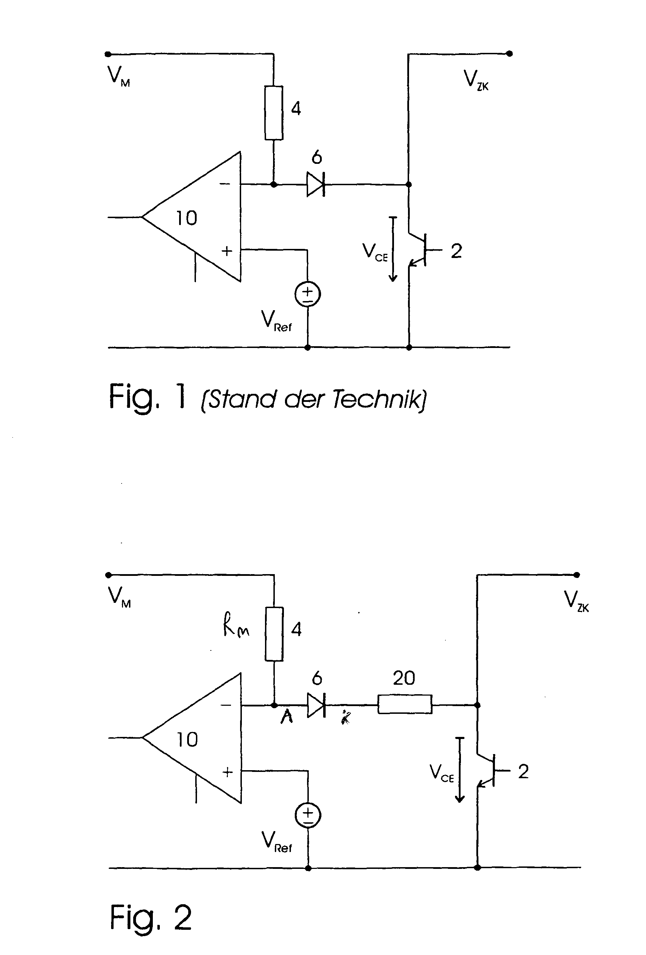

Die Erfindung betrifft eine Schaltungsanordnung und ein Verfahren zum Schutz von Leistungshalbleiterschaltern vor einem zu hohen Durchlassstrom (Überstrom) und vor zu hoher Temperatur (Übertemperatur). Schutzschaltungen vor einem zu hohem Durchlassstrom bzw. zum Schutz vor zu hoher Temperatur sind beispielhaft aus U. Nicolai et al., "Applikationshandbuch IGBT- und MOSFET- Leistungsmodule", ISBN 3-932633-24-5, Seite 206f. bzw. 214f und auch US 5 978 194 bekannt. Im folgenden wird zur Vereinfachung davon ausgegangen, dass der Leistungshalbleiterschalter ein Bipolartransistor oder ein IGBT ist. Selbstverständlich sind auch alle anderen Leistungshalbleiterschalter wie z.B. Feldeffekttransistoren in gleicher Weise zu betrachten. Eine V_{CE}- Überwachung eines Bipolartransistors bzw. IGBTs entspricht demnach der V_{RDS(on)}- Überwachung eines Feldeffekttransistors. Den Stand der Technik bilden die Überstromüberwachung, hier V_{CE}-Überwachung (vgl. Fig. 1), sowie eine Temperaturüberwachung, wie sie im folgenden beschrieben werden.

Die V_{CE}- Überwachung nutzt den physikalischen Zusammenhang zwischen dem Kollektorstrom und der Durchlassspannung. Hierzu wird die Kollektor- Emitter- Spannung mit einer hochsperrenden Diode erfasst und mit einem Referenzwert verglichen. Bei Überschreiten dieses Referenzwertes erfolgt die Fehlermeldung an eine übergeordnete Steuerung sowie das Abschalten des Transistors. Durch die schnelle Entsättigung des Transistors können Kurzschlüsse auf diese Weise sehr gut erfasst werden.

Die Temperaturüberwachung erfolgt über einen Temperatursensor, der gemeinsam mit dem Transistor auf einem Substrat angeordnet ist. Diese Anordnung findet beispielsweise in Leistungshalbleitermodulen nach dem Stand der Technik Verwendung. Bei derartigen Leistungshalbleitermodulen kann der Sensor auch außerhalb des Moduls beispielsweise auf einem Kühlkörper angeordnet sein. Eine alternative Anordnung des Temperatursensors ist eine direkte stoffbündige Verbindung mit dem Transistor bzw. dessen Gehäuse.

Nachteilig am Stand der Technik ist, dass für beide Überwachungsaufgaben, die V_{CE}-Überwachung sowie die der Temperaturüberwachung, jeweils getrennte Überwachungsschaltungen notwendig sind. Hierfür sind auch entsprechende Anschlüsse an dem Leistungshalbleitermodul vorzusehen. Die genannten Nachteile kommen vorrangig im Bereich kostengünstiger Leistungshalbleitermodule kleinerer Leistung zum Tragen.

Der vorliegenden Erfindung liegt die Aufgabe zugrunde eine Schaltungsanordnung sowie ein dazugehöriges Verfahren zur Auswertung für einen oder mehrere Leistungshalbleiterschalter oder ein daraus aufgebautes Leistungshalbleitermodul vorzustellen, die einen Schutz gegen Überstrom und Übertemperatur zur Verfügung stellen und die mit einer geringen Anzahl von Standardbauelementen herstellbar ist.

Die Aufgabe wird gelöst durch die Maßnahmen des Anspruchs 1 und 5. Weitere vorteilhafte Ausgestaltungen sind in den Unteransprüchen genannt.

Der Grundgedanke der Erfindung liegt darin, die Standardbeschaltung zur V_{CE}-Überwachung nach Fig. 1 um einen PTC- Widerstand (PTC = positive temperature coefficient), geschaltet zwischen die Kathode der Diode und den Stromeingang des Leistungshalbleiterschalters, zu erweitern. Der PTC- Widerstand sollte dabei möglichst nahe am Leistungshalbleiterschalter angeordnet werden, um dessen Temperatur möglichst präzise zu erfassen. Aufgrund dieses zusätzlichen Widerstandes muss der Wert der Referenzspannungsquelle entsprechend angepasst werden. Dadurch wird die Funktion der Schaltungsanordnung als V_{CE}- Überwachung unverändert beibehalten. Die gleichzeitig bestehende Funktion als Temperaturüberwachung wird folgendermaßen erfüllt. Der PTC sollte derart ausgewählt sein, dass der starke nicht lineare Anstieg seines Widerstandes kurz vor der Temperatur liegt und bei der die Überwachung aktiv werden soll. Eine Erhöhung der Temperatur des Leistungshalbleiterschalters und damit des PTC- Widerstandes führt in diesem Fall zu einem starken Anstieg des Widerstandwertes des PTC- Widerstandes und damit zu einem höheren Spannungsabfall in diesem Zweig der Schaltungsanordnung. Somit wird die nachgeordnete V_{CE}- Überwachungsschaltung aktiviert, mit dem Unterschied, dass nicht der V_{CE}- Anstieg, sondern der Temperaturanstieg Auslöser für die Reaktion der nachgeordneten Schaltung, d.h. eine Reduktion der Leistung oder die Abschaltung des Leistungshalbleiterschalters, ist. Somit kann mit dieser erfinderischen Schaltungsanordnung und nur einer Überwachungsschaltung die Funktion der V_{CE}- Überwachung und die Funktion der Übertemperaturüberwachung gleichzeitig erfüllt werden.

Die erfinderische Lösung wird an Hand der Fig. 1 und 2 weiter erläutert.

Fig. 1 zeigt eine V_{CE}- Überwachungsschaltung nach dem Stand der Technik, bestehend aus einem Transistor (2) zur Schaltung einer Spannung (U_{ZK}), einem Messkreis mit einer Spannungsquelle (V_{M}), einem Widerstand (4), einer schnellen hochsperrenden Diode (6), sowie einer Referenzspannungsquelle (V_{Ref}) und einem Vergleichsglied (10). Die Kollektor-Emitter- Spannung des Transistors (2) wird mittels folgender Schaltungsanordnung überwacht. Der Referenzeingang des Vergleichsgliedes (10) ist mit dem Pluspol der Referenzspannungsquelle (V_{Ref}) verbunden. Der Minuspol der Referenzspannungsquelle (V_{Ref}) liegt auf dem Potential des Emitters des Transistors. Der zweite Eingang des Vergleichsgliedes (10) wird mit der Anode der Diode (6) und wie dieser über den Widerstand (4) mit der Spannungsquelle (V_{M}) verbunden. Die Kathode der Diode (10) ist mit dem Kollektor des Transistors (2) verbunden.

Die Spannung über dem Transistor (2) wird mittels der Diode (6) überwacht und mittels des Vergleichsgliedes (10) mit dem Referenzwert (V_{Ref}) verglichen. Steigt die Spannung über dem Transistor (V_{CE}) über den eingestellten Referenzwert, erzeugt das Vergleichsgliedes (10) eine Fehlermeldung und der Transistor wird abgeschaltet.

Beispielhaft löst hier eine V_{CE}- Spannung von 4V die Abschaltfunktion der nachgeordneten Schaltung aus. Zur V_{CE}- Überwachung wird somit bei einem Spannungsabfall von 0,5V über der Diode (6) und der gegebenen Auslöseschwelle (V_{CEsat}) von 4V die Referenzspannung auf 4,5V eingestellt.

Fig. 2 zeigt die erfinderische Erweiterung einer Schaltungsanordnung zur V_{CE}- Überwachung eines Transistors (2). Hier wird bei sonst unveränderter Schaltungsanordnung gegenüber Fig. 1 ein PTC- Widerstand (20) zwischen der Kathode der Diode (6) und dem Kollektor des Transistors (2) angeordnet, dessen Ohmscher Widerstand bei normalen Betriebstemperaturen bei ca. 1kOhm liegt. Bei einem Messstrom von I_{M} = 1mA entspricht dies einem Spannungsabfall von 1V über dem PTC- Widerstand (20). Daher muss die Referenzspannung (V_{Ref}) um diesem Wert gegenüber der reinen V_{CE}- Überwachung angehoben werden. Somit sind die Verhältnisse für die Funktion der V_{CE}- Überwachung identisch mit dem Stand der Technik.

Zur V_{CE}- Überwachung wird somit bei einem Spannungsabfall von 0,5V über der Diode (6) und der gegebenen Auslöseschwelle (V_{CEsat}) von 4V und einem Spannungsabfall von 1V über dem PTC- Widerstand die Referenzspannung auf 5,5V eingestellt.

Die Abschaltung bei Übertemperatur erfolgt folgendermaßen. Bei geeignet gewähltem PTC-Widerstand steigt der Ohmsche Widerstand zwischen 100°C und 140°C auf über 500kOhm. Damit entsteht ein genügend großer Spannungsabfall über dem Messzweig um ebenfalls die Abschaltfunktion der nachgeordneten Schaltung auszulösen.

Beispielhaft sei von einer V_{CE}- Spannung von 2V, also unterhalb von V_{CESat} = 4V ausgegangen, dann muss der Spannungsabfall über dem PTC- Widerstand 3V zur Abschaltung betragen, dies entspricht dem Widerstandswert von 3kOhm. Dies wird bei einem gängigen PTC z.B. durch die Steigerung der Temperatur von 110°C auf 115°C erreicht.

Selbstverständlich können durch die geeignete Wahl des PTC- Widerstandes die Abschalttemperaturen an den jeweiligen Anwendungsfall angepasst werden.

## Patentansprüche

1. Schaltungsanordnung zum Überstrom- und Übertemperaturschutz von Leistungshalbleiterschaltern (2) oder daraus aufgebauter Leistungshalbleitermodule bestehend aus einer als V_{CEsat}- bzw. V_{Dson}- Überwachung ausgebildeten Überstromschutzschaltung wobei diese aus einer Spannungsquelle (V_{M}), einem Vergleichsglied (10), einer hochsperrenden schnellen Diode (6) und einer Referenzspannungsquelle (V_{Ref}) besteht,
und wobei der Referenzeingang des Vergleichsgliedes (10) mit dem Pluspol der Referenzspannungsquelle (V_{Ref}) verbunden ist und deren Minuspol auf dem Potential des Stromausgangs des zu überwachenden Leistungshalbleiterschalters (2) liegt, die Anode der Diode (6) über einen Widerstand (4) mit der Spannungsquelle (V_{M}) sowie dem zweiten Eingang des Vergleichsgliedes (10) verbunden ist und
die Kathode der Diode (6) mit dem PTC- Widerstand (20) und dieser mit dem Stromeingang des Leistungshalbleiterschalters (2) verbunden ist.

2. Schaltungsanordnung nach Anspruch 1, wobei der Leistungshalbleiterschalter (2) ein IGBT oder ein Biopolartransistor ist, dessen Kollektor der Stromeingang sowie dessen Emitter der Stromausgang ist.

3. Schaltungsanordnung nach Anspruch 1, wobei der Leistungshalbleiterschalter (2) ein Feldeffekttransistor ist, dessen Source der Stromeingang sowie dessen Drain der Stromausgang ist.

4. Verfahren zur Feststellung von Überstrom- und / oder Übertemperatur von Leistungshalbleiterschaltern (2) oder daraus aufgebauter Leistungshalbleitermodule nach Anspruch 1 wobei der sich mit der Temperatur ändernde Spannungsabfall über diesem PTC- Widerstand (20) zur Detektion der Übertemperatur dient und dieser Spannungsabfall mittels der Überstromschutzschaltung ausgewertet wird.

## Claims

1. Circuit arrangement for over-current and excess temperature protection of power semiconductor circuits (2) or power semiconductor modules constructed therefrom, consisting of an over-current protection circuit constructed as a V_{CEsat}- or V_{DSon}-monitoring circuit, wherein said circuit consists of a voltage source (V_{M}), a comparator element (10), a high-blocking capability fast diode (6) and a reference voltage source (V_{Ref}),
and wherein the reference input of the comparator element (10) is connected to the plus terminal of the reference voltage source (V_{Ref}) and the minus terminal thereof is at the potential of the current output of the power semiconductor circuit (2) to be monitored, the anode of the diode (6) is connected via a resistor (4) to the voltage source(V_{M}) and to the second input of the comparator element (10), and the cathode of the diode (6) is connected to the PTC-resistor (20), which is connected to the current input of the power semiconductor circuit (2).

2. Circuit arrangement according to Claim 1, wherein the power semiconductor circuit (2) is an IBGT or bipolar transistor, the collector of which is the current input and the emitter of which is the current output.

3. Circuit arrangement according to Claim 1, wherein the power semiconductor circuit (2) is a field-effect transistor, the source of which is the current input and the drain of which is the current output.

4. Method for the detection of over-current and/or excess temperature of power semiconductor circuits (2) or power semiconductor modules constructed therefrom according to Claim 1, wherein the voltage drop across the said PTC resistor (20) that varies with the temperature is used for detecting the temperature, and the said voltage drop is analysed using the over-current protection circuit.

## Revendications

1. Agencement de circuit pour la protection contre le courant excessif et le suréchauffement d'interrupteurs à semi-conducteurs de puissance (2) ou de modules à semi-conducteurs de puissance conçus sur cette base comprenant un circuit de protection de surintensité conçu comme un contrôle V_{CEsat} ou contrôle V_{Dson}, ce circuit comprenant une source de tension (V_{M}), un élément de comparaison (10), une diode (6) rapide à blocage élevé et une source de tension de référence (V_{Ref}),
et l'entrée de référence de l'élément de comparaison (10) étant reliée au pôle plus de la source de tension de référence (V_{Ref}) et son pôle moins étant situé sur le potentiel de la sortie de courant de l'interrupteur à semi-conducteurs de puissance (2) à contrôler, l'anode de la diode (6) étant reliée par une résistance (4) à la source de tension (V_{M}) et à la seconde entrée de l'élément de comparaison (10) et la cathode de la diode (6) étant reliée à la résistance PTC (20) et celle-ci étant reliée à l'entrée de courant de l'interrupteur à semi-conducteurs de puissance (2).

2. Agencement de circuit selon la revendication 1, l'interrupteur à semi-conducteurs de puissance (2) étant un IGBT ou un transistor bipolaire, dont le collecteur est l'entrée de courant et son émetteur la sortie de courant.

3. Agencement de circuit selon la revendication 1, l'interrupteur à semi-conducteurs de puissance (2) étant un transistor à effet de champ, dont la source est l'entrée du courant et son drain la sortie du courant.

4. Procédé pour déterminer le courant excessif et/ou le suréchauffement d'interrupteurs à semi-conducteurs de puissance (2) ou de modules à semi-conducteurs de puissance conçus sur cette base selon la revendication 1, la chute de tension variant avec la température sur cette résistance PTC (20) servant à la détection de l'échauffement et cette source de tension étant analysée au moyen du circuit de protection de surintensité.
